# FASCICULE DE BREVET EUROPEEN

(11) **EP 2 341 611 B1**
(45) Date de publication et mention de la délivrance du brevet: **20.03.2013**
(21) Numéro de dépôt: 10354088.6
(22) Date de dépôt: 07.12.2010
(51) Int. Cl.: H03L 1/00, H03B 5/06, H03K 3/014, H03L 3/00, H03B 5/36

(54) **Oscillateur à quartz à démarrage rapide et faible consommation de courant**
Schnellstart-Quartz-Oszillator mit geringem Stromverbrauch
Crystal oscillator with fast start-up and low current consumption

(30) Priorité: 22.12.2009 FR 0906234
(43) Date de publication de la demande: 06.07.2011
(73) Titulaire: STMicroelectronics (Grenoble 2) SAS, 38000 Grenoble (FR)
(72) Inventeur: Ramet, Serge, 38560 Jarrie (FR)
(74) Mandataire: de Jong, Jean Jacques

(56) Documents cités:
- US-A1- 2008 100 390
- US-B1- 6 194 973
- US-B2- 7 598 821

## Description

### Domaine technique de l'invention

L'invention est relative aux oscillateurs à résonateur à quartz, notamment de tels oscillateurs à démarrage rapide.

### État de la technique

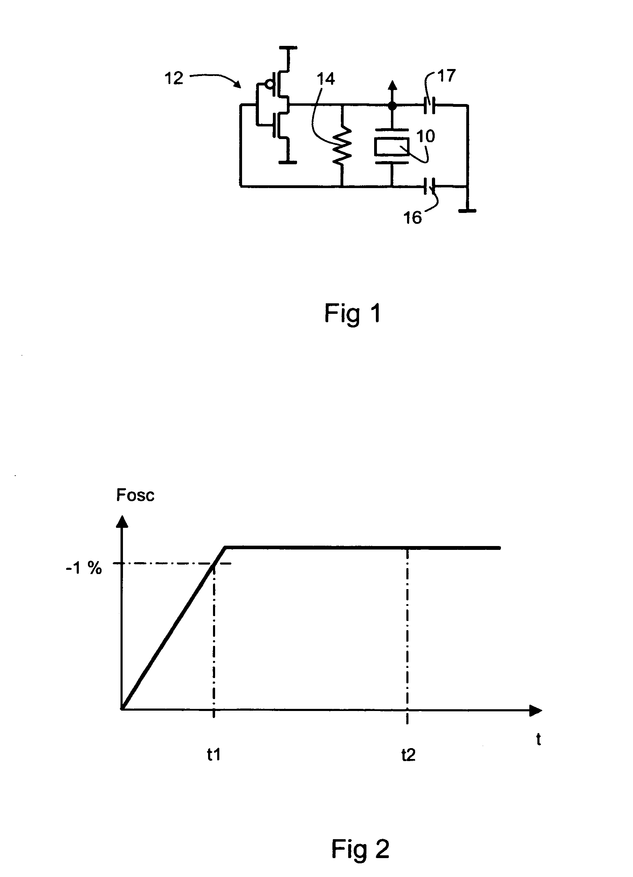

La figure 1 représente un schéma de base d'un oscillateur à résonateur à quartz. Le résonateur 10 est connecté entre l'entrée et la sortie d'un inverseur 12 constitué de deux transistors complémentaires. La sortie de l'oscillateur est prélevée sur la sortie de l'inverseur.

Le point de repos de l'inverseur est fixé grâce à une résistance 14 connectée entre l'entrée et la sortie de l'inverseur. Un réseau de correction de fréquence comprenant deux condensateurs 16 et 17, reliant respectivement les bornes du résonateur à un potentiel de référence, permet l'ajustement de la fréquence de l'oscillateur.

La figure 2 est une courbe schématique représentant l'évolution dans le temps de la fréquence d'oscillation d'un oscillateur du type de la figure 1 lors de son démarrage. À partir de t = 0, la fréquence croît progressivement pour rejoindre asymptotiquement une valeur nominale.

Comme on peut le constater, l'oscillateur n'est pas exploitable immédiatement. On distingue souvent deux conditions d'utilisation de l'oscillateur à partir du démarrage. Un instant t1 définit des conditions à partir desquelles on peut commencer à cadencer un microcontrôleur pour certaines taches de démarrage ne nécessitant pas une grande précision de fréquence. La précision de la fréquence à l'instant t1 est par exemple de -1 %.

À partir d'un instant t2 on souhaite que l'oscillateur ait atteint sa précision maximale, par exemple de 10 ppm.

Le souhait d'utiliser un microcontrôleur dès l'instant t1 existe dans le cadre des applications basse consommation, où un appareil sort régulièrement d'un état de veille pour vérifier s'il y a une tache à faire. S'il n'y a pas de tache à faire, l'appareil se remet en veille. On a donc intérêt à ce que l'instant t1 arrive rapidement après un démarrage et que la consommation d'énergie nécessaire pour atteindre cet instant soit minimale. On souhaite par exemple que le temps t1 soit inférieur à 800 *µ*s.

Le temps t2, à partir duquel la précision maximale de l'oscillateur est atteinte, est par exemple de 4,5 ms. On peut souhaiter que l'oscillateur consomme une énergie minimale à partir de cet instant, en régime établi, tout en garantissant cette précision.

Il s'avère toutefois que le courant minimal permettant d'entretenir l'oscillateur dans son régime établi ne permet pas à l'oscillateur de démarrer suffisamment vite pour atteindre un instant t1 inférieur aux valeurs souhaitées aujourd'hui (800 *µ*s).

Il est établi que la vitesse de démarrage de l'oscillateur croît avec le courant. On a donc intérêt à alimenter l'oscillateur avec un courant élevé au démarrage pour qu'il démarre vite, puis à réduire le courant en régime établi afin de réduire la consommation.

Il existe des structures d'oscillateur où l'inverseur 12 est remplacé par un amplificateur en courant à gain variable afin d'asservir le gain inversement à l'amplitude d'oscillation. Le but d'une telle structure est principalement d'assurer que l'amplitude d'oscillation en régime établi n'atteint pas les limites d'écrêtage, ceci afin d'éviter des phénomènes nuisant au bon fonctionnement de l'oscillateur et des circuits qu'il alimente. Dans une telle structure, il s'avère que l'oscillateur se trouve alimenté avec un courant plus élevé au démarrage qu'en régime établi.

Un tel oscillateur est décrit, par exemple, dans le brevet US7262671et US 7 598 821. Il comprennent un transistor externe à l'inverseur, connecté en miroir de courant avec le transistor P de l'inverseur, de sorte que le transistor de l'inverseur recopie le courant du transistor externe. Ce transistor externe a sa borne de drain reliée aux bornes de grille du transistor de l'inverseur et du transistor externe. Une source de courant alimente le transistor externe avec un courant fixe, auquel un circuit de régulation superpose un courant variable qui est une fonction inverse de l'amplitude d'oscillation.

La régulation doit comporter une plage linéaire, et elle est optimisée pour éviter l'écrêtage en régime établi. Les caractéristiques de cette régulation dépendent du dimensionnement de transistors, et sont donc susceptibles de varier en fonction de la température et des aléas du procédé de fabrication. En outre, la régulation n'est pas prévue pour optimiser la vitesse de démarrage et la consommation de courant en régime établi. Du fait que le circuit comprend des branches avec quatre transistors en série entre les bornes d'alimentation, il est peu adapté à une utilisation sous de faibles tensions d'alimentation.

### Résumé de l'invention

Il subsiste ainsi un besoin de prévoir un oscillateur à résonateur à quartz capable de démarrer rapidement tout en présentant une faible consommation en régime établi. On souhaite en outre que la solution soit peu sensible à la température et aux aléas de fabrication.

Pour contribuer à satisfaire ce besoin, on prévoit notamment de démarrer l'oscillateur en l'alimentant avec un courant de démarrage ; d'attendre la fin d'une phase de latence sans oscillations, inhérente à l'utilisation d'un résonateur à quartz ; et d'alimenter l'oscillateur avec un courant inférieur au courant de démarrage à partir d'un instant entre la fin de la phase de latence et l'établissement d'un régime établi.

On prévoit également un oscillateur selon la revendication 1.

Le commutateur est de préférence interposé entre le drain du transistor externe et le noeud de connexion entre la grille du transistor de l'inverseur et la source de courant.

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :
- la figure 1, précédemment décrite, est un schéma de principe d'un oscillateur à résonateur à quartz ;
- la figure 2, précédemment décrite, représente une variation de la fréquence d'oscillation au démarrage d'un tel oscillateur ;
- la figure 3 représente un schéma de principe d'un mode de réalisation d'oscillateur à quartz optimisé en vitesse de démarrage et en consommation ; et
- la figure 4 représente un exemple détaillé du mode de réalisation de la figure 3.

### Description d'un mode de réalisation préféré de l'invention

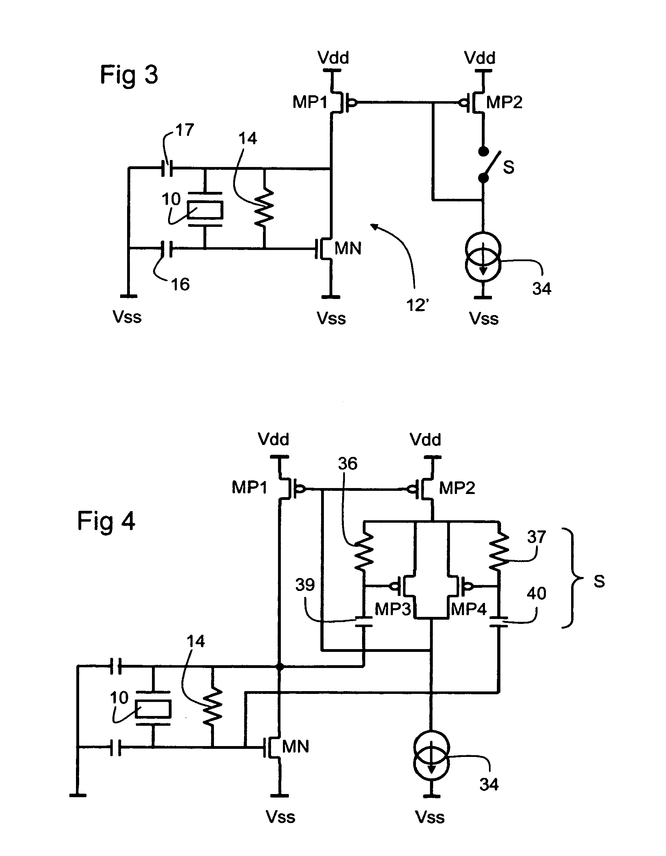

À la figure 3, dans un mode de réalisation d'oscillateur à quartz optimisé, on retrouve des mêmes éléments qu'à la figure 1, désignés par des mêmes références, notamment le résonateur à quartz 10 associé à ses éléments de compensation de fréquence (condensateurs 16, 17) et de polarisation de l'inverseur (résistance 14).

L'inverseur, désigné ici par 12', est de structure différente de celui de la figure 1. Il comprend un transistor MOS à canal N MN dont la source est reliée à une ligne d'alimentation de potentiel bas Vss, la grille est reliée à une première borne du résonateur 10, et le drain est relié à la deuxième borne du résonateur 10. Un transistor MOS à canal P MP1 a son drain relié au drain du transistor MN, et sa source reliée à une ligne d'alimentation de potentiel haut Vdd. La grille du transistor MP1, au lieu d'être reliée à la grille du transistor MN comme dans une configuration d'inverseur classique (figure 1), est reliée à la ligne Vss par une source de courant 34.

Un transistor MOS à canal P MP2 est connecté en parallèle par sa grille et sa source au transistor MP1. Le drain et la grille du transistor MP2 sont reliés entre eux par un commutateur S.

En régime établi, le commutateur S est fermé. On s'aperçoit que le transistor MP2 est alors connecté en diode, et que le transistor MP1 est monté en miroir de courant avec le transistor MP2, de sorte à recopier le courant imposé dans le transistor MP2 par la source de courant 34, avec un facteur multiplicatif correspondant au rapport de tailles des transistors MP1 et MP2.

Dans cette configuration, l'inverseur 12' a une structure à charge active (formée par le transistor MP1 agissant comme une source de courant constant), au lieu d'avoir une structure à transistors complémentaires (figure 1). Le courant du transistor MP1 est de préférence réglé au minimum requis pour entretenir l'oscillation en régime établi, par exemple 300 *µ*A.

Au démarrage, le commutateur S est ouvert. Le transistor MP2 n'est plus connecté en diode et la source de courant 34 parvient à tirer la grille du transistor MP1 vers le potentiel bas Vss. Le transistor MP1 devient totalement passant et constitue une charge résistive de faible impédance. L'inverseur 12' fonctionne donc avec un courant élevé, propice à accélérer le démarrage de l'oscillation. La taille du transistor MP1 détermine le courant maximal souhaité au démarrage.

Ainsi, le commutateur S est commandé pour être initialement ouvert, puis fermé lorsque l'oscillateur atteint son régime établi. La fonction du commutateur S étant d'interrompre le courant dans le transistor MP2, afin que le courant de la source 34 soit dirigé vers la grille du transistor MP1, d'autres configurations de ce commutateur sont possibles. Il peut être placé, par exemple, entre la source du transistor MP2 et la ligne Vdd.

On préfère réduire la durée pendant laquelle le courant maximal de démarrage est consommé. On cherche alors à fermer le commutateur S bien avant l'établissement du régime établi sans pénaliser la vitesse de démarrage.

Il se trouve que le fait d'avoir un courant élevé n'est pas utile sur toute la phase de démarrage. Il suffit que le courant soit élevé seulement pendant une phase initiale de latence où l'amplitude d'oscillation reste nulle. Ce phénomène de latence a été relevé, par exemple, dans l'article « The current dependence of crystal unit resistance at low drive level », Shunsuke NONAKA, Tasuku YUUKI, Koich HARA, Nippon Electric Company, Transmission Division, Shimonumabe, Kawasaki, Japon. En effet, un résonateur à quartz est soumis à des frottements mécaniques s'opposant à son oscillation et qu'il faut vaincre pour qu'il se mette à osciller. Ces frottements sont vaincus par un apport d'énergie devant dépasser un seuil. Une fois le seuil d'énergie atteint, l'oscillation démarre, et la valeur du courant influe alors moins sur la suite du démarrage.

Ainsi, selon une variante avantageuse, au démarrage de l'oscillateur, le commutateur S, initialement ouvert pour imposer un courant de démarrage élevé, est fermé dès qu'on détecte l'apparition des oscillations.

En pratique, comme il est difficile de détecter le démarrage d'une oscillation, on préférera prévoir une commutation progressive, amorcée au démarrage de l'oscillation.

La figure 4 représente un mode de réalisation offrant une telle commutation progressive. Le commutateur S comprend deux transistors MOS à canal P, MP3 et MP4, connectés en parallèle par leurs drains et sources entre le transistor MP2 et la source de courant 34. Les grilles des transistors MP3 et MP4 sont connectées au drain du transistor MP2 par des résistances respectives 36 et 37. Les grilles des transistors MP3 et MP4 sont par ailleurs connectées respectivement aux deux bornes du résonateur 10 par des condensateurs respectifs 39 et 40.

Les condensateurs 39, 40, associés aux résistances 36, 37, forment des filtres passe-haut entre les oscillations en opposition de phase présentes aux bornes du résonateur 10 et les grilles respectives des transistors MP3 et MP4.

En absence d'oscillations, notamment pendant la phase de latence au démarrage de l'oscillateur, les condensateurs 39, 40 conservent une charge constante et les résistances 36 et 37 maintiennent une tension nulle entre les grilles et les sources des transistors MP3 et MP4. Il en résulte que les transistors MP3 et MP4 sont bloqués, et donc que le commutateur S est ouvert. On se trouve dans une phase où le résonateur fonctionne à courant maximal.

Grâce au courant élevé, le résonateur arrive rapidement en fin de phase de latence, et se met progressivement à osciller. Les capacités 39, 40 transmettent chaque alternance des oscillations aux grilles des transistors MP3 et MP4. Les grilles de ces transistors voient des alternances oscillant autour du potentiel de source des transistors, et ceci en opposition de phase. Ainsi, tandis que l'un des transistors MP3, MP4 est bloqué par une alternance positive, l'autre transistor voit une alternance négative qui, si elle dépasse le seuil du transistor, rend le transistor conducteur.

Lorsque l'amplitude des oscillations est suffisante, les transistors MP3 et MP4 sont rendus conducteurs à tour de rôle, de sorte qu'une connexion permanente est établie entre le drain du transistor MP2 et la source de courant 34. Le commutateur S est alors fermé et assure le fonctionnement à courant minimal. Ce fonctionnement à courant minimal pourra être atteint bien avant que l'oscillateur n'atteigne son régime établi. Il suffit que l'amplitude des oscillations excède suffisamment le seuil des transistors MP3 et MP4.

On notera que ce mode de réalisation ne nécessite pas de précautions particulières quant au dimensionnement des composants pour assurer la commutation entre un régime de démarrage à courant élevé et un régime établi de l'oscillateur. Des variations des tensions de seuil des transistors MP3 et MP4 affecteront l'amplitude d'oscillation à partir de laquelle ces transistors se mettront à commuter, ce qui ne fait que décaler le passage au régime à courant minimal à l'intérieur de la phase de démarrage. Les variations dimensionnelles de transistors MP3 et MP4 laissent également une grande latitude. De telles variations affecteront la résistance à l'état passant des transistors. Cette résistance, parcourue par le courant de la source 34, provoque une chute de tension parasite aux bornes des transistors MP3 et MP4 qui tend à modifier la polarisation du transistor MP1, et donc à modifier la consommation de courant en régime établi. Toutefois, comme le courant de la source 34 est choisi particulièrement faible (il est multiplié par le rapport de surface des transistors MP1 et MP2), cette chute de tension parasite reste négligeable, même pour la taille minimale des transistors MP3 et MP4.

Les valeurs des résistances 36, 37 et des condensateurs 39, 40 ont peu d'influence sur les caractéristiques de la commutation. Elles ont une certaine influence sur la consommation de courant et la taille du circuit, donc on préférera les choisir pour obtenir un bon compromis, mais il n'est pas nécessaire de tenir compte de leur variabilité.

Les modes de réalisation d'oscillateur décrits ici ne visent pas directement le problème de l'écrêtage des oscillations et le contrôle de leur amplitude. Ce problème est résolu automatiquement par le fait qu'on voudra choisir un courant de régime établi aussi faible que possible. Comme l'amplitude des oscillations a tendance à varier dans le sens de ce courant, cette amplitude est naturellement sous contrôle.

On trouve au plus trois transistors en série entre les lignes d'alimentation, ce qui permet d'alimenter l'oscillateur sous de faibles tensions.

De nombreuses variantes et modifications des modes de réalisation décrits ici apparaîtront à l'homme du métier. Par exemple, on pourra remplacer des transistors à canal N par des transistors à canal P et des transistors à canal P par des transistors à canal N dans la figure 4.

## Revendications

1. Oscillateur comprenant:
- un inverseur (12') incluant un premier transistor MOS (MP1) connecté en charge active ;
- un résonateur (10) relié entre l'entrée et la sortie de l'inverseur ;
- un transistor connecté en diode (MP2) et formant un miroir de courant avec le premier transistor (MP1), de manière que le premier transistor recopie le courant dans le transistor connecté en diode ; et
- une source de courant (34) connectée pour imposer le courant dans le transistor connecté en diode (MP2) ;
**caractérisé en ce qu'**il comprend un commutateur (S) connecté pour interrompre le courant dans le transistor connecté en diode (MP2) au début d'une phase de démarrage de l'oscillateur, d'où il résulte que la source de courant parvient à tirer la grille du premier transistor (MP1) vers un potentiel tel que le premier transistor (MP1) devient totalement passant.

2. Oscillateur selon la revendication 1, dans lequel le commutateur (S) est interposé entre le drain du transistor connecté en diode (MP2) et le noeud de connexion entre la grille du premier transistor (MP1) et la source de courant (34).

3. Oscillateur selon la revendication 2, dans lequel le commutateur (S) comprend deux transistors reliés en parallèle (MP3, MP4), dont les grilles sont reliées respectivement à l'entrée et à la sortie de l'inverseur par l'intermédiaire de filtres passe-haut (39-36, 40-37).

## Claims

1. An oscillator comprising:
• an inverter (12') including a first MOS transistor (MP1) connected as an active load;
• a resonator (10) connected between the input and the output of the inverter;
• a diode-connected transistor (MP2) forming a current mirror with the first transistor (MP1), such that the first transistor copies the current in the diode-connected transistor, and
• a current source (34) connected to set the current in the diode-connected transistor (MP2);
**characterized in that** it comprises a switch (S) connected for interrupting the current in the diode-connected transistor (MP2) at the beginning of a start-up phase of the oscillator, whereby the current source pulls the gate of the first transistor (MP1) to a voltage such that the first transistor (MP1) becomes entirely conductive.

2. The oscillator of claim 1, wherein the switch (S) is interposed between the drain of the diode-connected transistor (MP2) and the connection node between the gate of the first transistor (MP1) and the current source (34).

3. The oscillator of claim 2, wherein the switch (S) comprises two transistors connected in parallel (MP3, MP4), whose gates are connected respectively to the input and the output of the inverter through high-pass filters (39-36, 40-37).

## Patentansprüche

1. Oszillator umfassend:
- einen Umkehrschalter (12'), der einen ersten als Wirklast geschalteten MOS-Transistor (MP1) beinhaltet;
- einen Resonator (10), der zwischen dem Eingang und dem Ausgang des Umkehrschalters verbunden ist;
- einen als Diode geschalteten Transistor (MP2), der derart einen Stromspiegel mit dem ersten Transistor (MP1) bildet, dass der erste Transistor den Strom in den als Diode geschalteten Transistor kopiert; und
- eine Stromquelle (34), die angeschlossen ist, um den Strom in den als Diode geschalteten Transistor (MP2) aufzuerlegen;
**dadurch gekennzeichnet, dass** er einen Schalter (S) umfasst, der angeschlossen ist, um den Strom im als Diode geschalteten Transistor (MP2) zu Beginn einer Startphase des Oszillators zu unterbrechen, woraus sich ergibt, dass die Stromquelle das Gitter des ersten Transistors (MP1) derart zu einem Potential ziehen kann, dass der erste Transistor (MP1) vollkommen durchlassend wird.

2. Oszillator nach Anspruch 1, in dem der Schalter (S) zwischen den Drain des als Diode geschalteten Transistors (MP2) und den Anschlussknoten zwischen dem Gitter des ersten Transistors (MP1) und der Stromquelle (34) geschaltet ist.

3. Oszillator nach Anspruch 2, in dem der Schalter (S) zwei Transistoren (MP3, MP4) umfasst, die parallel miteinander verbunden sind und deren Gitter jeweils mit dem Eingang und mit dem Ausgang des Umkehrschalters über Hochpassfilter (39-36, 40-37) verbunden sind.
